# EUROPEAN PATENT APPLICATION

(11) **EP 4 592 196 A1**
(43) Date of publication of application: **30.07.2025**
(21) Application number: 24217174.2
(22) Date of filing: 03.12.2024
(51) Int. Cl.: B64D 37/02, B64D 37/04, B64D 37/30, B64F 5/00, G06F 30/15

(54) **ENVIRONMENTALLY FRIENDLY AIRCRAFT**

(30) Priority: 25.01.2024 US 202418422662
(71) Applicant: Embraer S.A., 12227-901 São José Dos Campos SP (BR)
(72) Inventor: RIBEIRO, Raphael Felipe Gama, 12.227-901 São José dos Campos - SP (BR); TRAPP, Luis Gustavo, 12.227-901 São José dos Campos - SP (BR); AFFONSO, Luis Carlos, 12.227-901 São José dos Campos - SP (BR)
(74) Representative: Liesegang, Eva

(57) **Abstract**

An aircraft stores cryogenic fuel in one or more right sized fuel tanks inside the aircraft fuselage or at other appropriate positions on the aircraft, and stores non-cryogenic fuel in plural standard jet fuel tanks e.g., inside the aircraft wings. The tanks are sized to using an automated aircraft sizing computational tool based on the defined missions ranges requirements, tanks sizing logic, Top-Level Aircraft Requirements, and aircraft geometry and engine thrust levels, to iteratively develop at least cryogenic fuel tank size for a particular aircraft. A controller controls selective routing of non-cryogenic fuel or cryogenic (e.g., hydrogen) fuel to dual fuel engines. In one operating mode, the dual fuel engines normally use the cryogenic hydrogen fuel as the main fuel, and reserve the non-cryogenic fuel for application to the dual fuel engines only on an exception basis, thereby providing cleaner and more environmentally friendly operation.

## Description

### CROSS-REFERENCE TO RELATED APPLICATION

This application is a continuation-in-part of application no. 17/864,974 filed 07/14/2022, which claims the benefit of Provisional Application No. 63/223,417 filed 7-19-2021, each of which are incorporated herein by reference in their entirety and for all purposes.

### FIELD

The example technology herein relates to aircraft design, and more particularly to aircraft operations, aircraft performance, aircraft fuel systems, and aircraft propulsion systems. Still more particularly, the example technology herein relates to aircraft designs for using alternative, environmentally friendly fuels such as hydrogen.

### BACKGROUND & SUMMARY

The aviation industry is searching for alternatives to decrease the environmental footprint of its products. One goal is to operate commercial aircraft in a way that provides no or only very low greenhouse gas emissions. Among the several potential options, hydrogen-based propulsion is one of the most promising for regional and narrow body aircraft.

Hydrogen provides advantages as an aviation fuel, such as high heating value (specific energy or energy to mass ratio) and specific heat (resulting in potentially greater engine efficiency). Additionally, its combustion does not produce carbon-based gases, which addresses the referenced environmental challenge. However, some important challenges arise from hydrogen usage: it has a very low energy density (energy to volume ratio), so it must be stored compressed or cryogenically liquified in order to decrease the installation burden, in terms of weight and drag, on the aircraft. Additionally, hydrogen tanks are heavy, and currently hydrogen cost per energy content is 3-4 times higher than the cost of standard fossil-based Jet Fuel. Therefore, different approaches must be taken in order to balance hydrogen benefits with its downsides.

Aircraft should be sized taking into account mission fuel reserves, which are important to provide contingency plans for pilots, if the destination airport is not able to authorize the landing of the aircraft and an alternate must be sought. Typically, reserves are translated to a diversion mission, with a fixed distance (100 - 200 nmi) plus loiter time (30 - 45 minutes). In the vast majority of the missions, the reserve fuel is not used.

For short range regional aircraft, the typical sector energy requirement is of similar order of magnitude to the reserve sector. Therefore, if hydrogen tanks were to be sized considering the typical mission plus reserves, they would have twice the volume and weight of hydrogen tanks sized only for the main mission. Given this fact, a strategy that minimizes the need of carrying hydrogen in case the aircraft needs to alternate to the very infrequent sector, is of interest.

In addition to the challenges discussed above, hydrogen production and infrastructure are also important points that need to be addressed. Hydrogen may be produced by different means, but in order to have net ("well to wake") emissions reductions, so-called "blue" or "green" hydrogen should be employed. Hydrogen is commonly produced from natural gas with a process of steam methane reforming, where natural gas is mixed with very hot steam and a catalyst. The result is H₂ and a COz byproduct. Unfortunately, producing one part hydrogen causes a release of nine parts of CO₂. If the COz byproduct is released to the atmosphere, the hydrogen produced is sometimes called "grey hydrogen". "Blue" hydrogen may be produced the same way but the COz byproduct is stored and contained or sold, instead of being released into the atmosphere. Hydrogen can also be produced by electrolysis of water, which produces Oz and Hz but no COz byproduct. When the electricity used to power electrolysis comes from renewable sources like wind, water or solar, the resulting hydrogen gas is said to be "green." Producing green hydrogen is currently much more expensive than producing blue hydrogen (because renewable sources of electricity are more expensive), but costs of green hydrogen are projected to come down substantially in the future. It is very likely that the blue / green hydrogen infrastructure will be built gradually in the future. See e.g., "Questions and answers: A Hydrogen Strategy for a climate neutral Europe", (European Commission 8 July 2020 Brussels)

An aircraft that runs only on hydrogen will only be able to fly routes where both airports of the flight terminus city pair have hydrogen refueling stations. Or alternatively, it will need hydrogen tanks large enough to carry hydrogen to use on the return flight, rendering its economic viability even more challenging. This lack of infrastructure risks retarding the adoption of hydrogen until it is available in the majority of airports.

Moreover, the hydrogen infrastructure will probably develop unevenly around the world. Specifically, more developed countries will likely be able to invest greater sums in economical, environmentally-friendly hydrogen production infrastructure as compared with underdeveloped countries. Therefore, an aircraft that is only able to operate with hydrogen as a fuel will not be able to operate globally after its certification and entry into service, which is an additional drawback to its economic feasibility.

Another challenge that needs to be addressed is the delivery process of a hydrogen aircraft, from its manufacturing plant to its operational hubs. An aircraft manufactured in a location A must have enough hydrogen refueling stations en route to reach its operating hub B. This may be a major challenge since a hydrogen aircraft will likely have smaller ranges than its fossil-based counterparts.

Finally, it is worth pointing out that although hydrogen combustion does not produce CO2, it does emit other potentially greenhouse gases, such as water vapor, contrails (condensation trails) and NOx. Contrails are human-made clouds. They form in air above about 25,000 feet, when that air is moist and colder than -40 degrees Celsius. Like regular clouds, they arise when water vapor, in this case from the engine exhausts, forms into droplets by condensing onto particles in the air. Within a second, the water droplets freeze to make tiny ice crystals that show up visually as contrails. Some claim contrails contribute to global warming. See e.g., Pearce, "How Airplane Contrails Are Helping Make the Planet Warmer" Yale School of the Environment (July 18, 2019).

Engine technologies such as combustion chamber optimization will likely be able to minimize NOx, and the impact of water vapor / contrails is greatly minimized if flight altitudes below a certain threshold (25 - 30kft) are used. These lower flight altitudes are more compatible with regional aircraft, so this aircraft category may be the best fit for hydrogen propulsion, at least in the shorter term.

Arguably, aircraft with higher payload range capabilities may not be able to use Fuel Cell systems since they typically are much heavier than gas turbines. In the last decades, a number of system concepts have been attempted in order to support the use of hydrogen in Gas Turbines. However, further improvements are possible and desirable.

### BRIEF DESCRIPTION OF THE DRAWINGS

Figure 1 is an example non-limiting schematic diagram of an aircraft propulsion and fuel system.
Figure 1A shows an example turboprop aircraft including both cryogenic and non-cryogenic fuel tanks.
Figure 2 shows an example system operation concept for a short, typical range mission.
Figure 3 shows an example system operation concept for an extended range mission.
Figure 4 shows an example system operation concept for pure SAF/Jet Fuel missions.
Figure 5 shows an example system concept operation for a contrail avoidance strategy.
Figure 6 shows an example system operation concept for a design range mission.
Figure 7 is a flowchart of example program control steps performed by a fuel controller.
Figure 8 shows an example Dual Fuel Aircraft "Fuel Tanks Right-Sizing" Design Process.
Figure 8A shows an example computer processing architecture.
Figure 9 shows example Ranges Accumulated Frequency.
Figure 10 shows example Payload Range Diagram With Associated Missions.
Figure 11 shows an example Aircraft Sizing Computational Tool Description.
Figures 12A, 12B show example aircraft having right sized fuel tanks..

### DETAILED DESCRIPTION OF NON-LIMITING EMBODIMENTS

As noted above, the literature is rich in dual fuel aircraft/engines examples but fails to disclose:
(1) An aircraft in which its fuel tanks (a: Cryogenic and b: Non-Cryogenic) are sized following the example non-limiting rationale below, denominated as "tanks right-sizing":
   a. Cryogenic fuel tanks are sized to provide enough energy for flight ranges up to and equal to a typical mission, which is shorter than the maximum range capability of the aircraft. (example design advantage: Cryogenic fuel tanks are bulky and heavy given thermal insulation and pressure requirements, therefore sizing them for a lower range capability results in a smaller and lighter aircraft.)
   b. Non-cryogenic fuel tanks are sized to provide energy for regulatory reserves and the remaining of the maximum range necessary to fulfill the design mission. Non-cryogenic fuel is much easier to be integrated into an aircraft, e.g. inside the aircraft wings.
(2) The design process to obtain such an aircraft.

Example Non-Limiting Embodiments Provide the following combinations of features:
An aircraft that has dual fuel engines, where one of the fuels consumed is a non-cryogenic (liquid at ambient temperature) fuel (Jet Fuel, Jet A, Jet A-1, Jet B, SAF, Avgas, Ethanol, etc.) and another fuel consumed is a cryogenic fuel such as liquid hydrogen or methane. In one embodiment, the cryogenic fuel could be fossil-based or non-fossil based but preferably comprises hydrogen. At temperatures typically encountered on board an aircraft, the cryogenic fuel is in the gaseous state which ordinarily would require large, heavy, high pressure storage vessels capable of withstanding 5000-10,000 psi. Such tanks may be too heavy and bulky for many or most aircraft. Therefore, in one embodiment, the cryogenic fuel is cooled to a liquid state before being loaded onto the aircraft so it can be stored compactly at low pressure.

For example, storage of hydrogen as a liquid requires cryogenic temperatures because the boiling point of hydrogen at one atmosphere pressure is - 252.8°C. Similarly, the boiling point of methane is -161.6°C. But if these fuels can be maintained at such cryogenic temperatures, they can be stored in low pressure, lighter weight vessels when compared to high pressure gaseous hydrogen tanks.

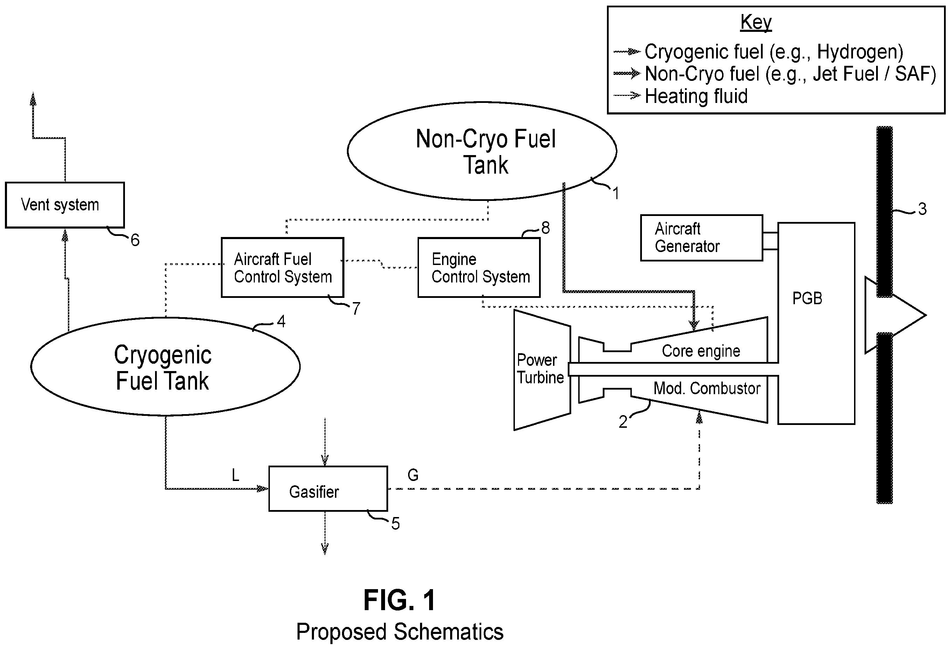

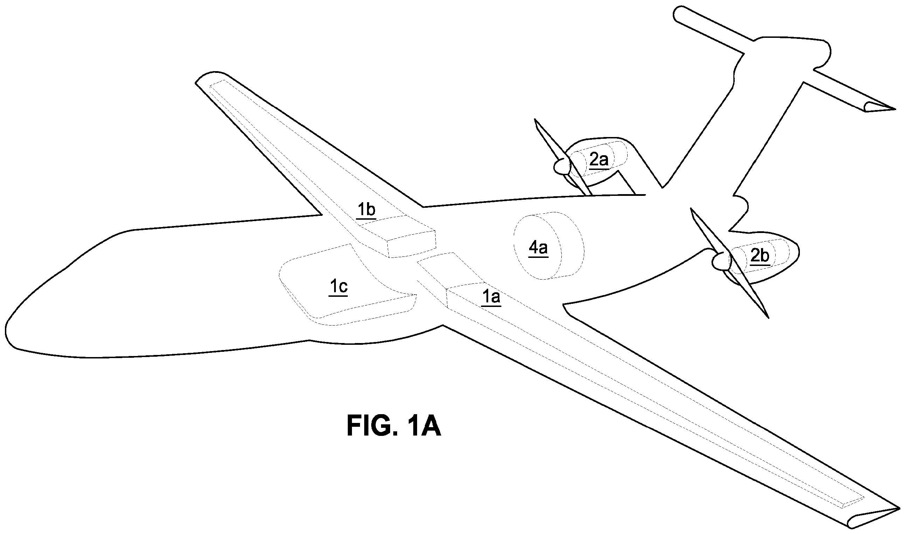

The cryogenic fuel is stored in one or more tanks inside the aircraft fuselage or at other appropriate positions (e.g. wing pods), and the non-cryogenic fuel is stored in two or more fuel tanks, located in standard positions, usually inside the left and right aircraft wings. See Figure 1a. In one embodiment, the cryogenic fuel is the main fuel that will normally be used for propelling the aircraft through the air, while the non-cryogenic fuel is a reserve or range extending fuel, which will be used only in special cases for propelling the aircraft through the air, including but not limited to:
- Reserve fuel, part of regulatory requirements to allow the aircraft to alternate to another airport destination.
- Reserve fuel in case of failure of a cryogenic fuel system component during flight, or to allow dispatching of the aircraft when the failure is identified on the ground.
- Reserve fuel for the next flight leg, in case the origin airport does not have a cryogenic fuel supply.
- Reserve fuel in case using non-cryogenic fuel in specific environmental or operational conditions increases aircraft safety.
- Contrails minimization, when using cryogenic fuel at certain atmospheric conditions leads to unwanted contrail formation.
- Range extending fuel, increasing the aircraft range when compared to a single cryogenic fuel aircraft.
- Supplementary fuel in critical flight cases, in order to increase safety during special environmental conditions (e.g. rain and hail), emergency flight conditions and/or to minimize the effects of hidden failures.

In one embodiment, the cryogenic fuel can be employed as the reserve fuel, extending the range of the aircraft when it is certain that successive destinations will not be able to resupply the aircraft with hydrogen, as will occur while the hydrogen infrastructure is being progressively expanded across the globe.

The non-cryogenic and cryogenic fuels can be used independently or in conjunction to provide energy for the engine.

The non-cryogenic fuel may be used as a motive fuel (e.g. engine variable inlet guide vanes actuation) or cooling fuel (e.g. engine and/or electric generator and/or electric motor oil cooler) at all flight phases, even when the cryogenic fuel is the only fuel being consumed by the engines, propelling the aircraft.

The cryogenic fuel can be used to cool or keep the non-cryogenic fuel temperatures down in order to reduce fuel vapors flammability inside the non-cryogenic fuel tank. The non-cryogenic fuel can be used to heat the cryogenic fuel before it enters the engines.

The control of the fuel mix is performed preferentially by the aircraft, considering, but not limited to:
- Amount of fuel in all tanks.
- Type of fuels (e.g. SAF or Jet Fuel) being carried.
- Environmental flight conditions (aiming to increase safety during rain and hail conditions, or minimize the formation of contrails, etc.).
- Environmental objectives in each flight phase.
- Component failures (including failure conditions where one engine is fed by the non-cryogenic fuel and the other by the cryogenic fuel).
- Economic conditions (such as the relative cost of each fuel or CO2 compensation schemes).
- Fuel availability at the destination.

### Expected Benefits of Example Embodiments

1) A lighter and more economical aircraft is obtained, when compared to an aircraft that is able to operate only with hydrogen:
   - Smaller and lighter hydrogen tanks: hydrogen fuel is sized for the typical mission, resulting in much smaller and lighter tanks than if they were to be sized for the design long range mission plus reserves. A smaller hydrogen tank may have a better form factor and increase its weight efficiency (gravimetric index).
   - Smaller and lighter hydrogen tanks present lower volume requirements, decreasing the aircraft required additional structures to support the tanks and associated wetted areas. This translates to decreased Operating Empty Weight and Drag, which results in smaller manufacturing and operating costs and environmental impacts.
   - Better aircraft weight and balance, since wing tanks are kept in the design and are closer to the aircraft center of gravity than the hydrogen tanks.
2) Reduced environmental footprint aircraft:
   - Aircraft will be able to optimize fuel usage to create less emissions, in terms of CO2, NOx, contrails and water vapor.
   - System allows earlier hydrogen fueled aircraft adoption while the supply infrastructure is not fully developed, enabling a faster and more widespread utilization of such aircraft.
   - Flexibility of selecting the most appropriate fuel capable of minimizing aircraft environmental footprint at any atmospheric condition.
3) Increased operational flexibility for aircraft:
   - Operators are provided with a new degree of freedom to optimize their businesses and operating networks, by trading off fuel availability, CO2 reduction, payload, range, and fuel costs at each specific route.
   - Operation in a much broader network is enabled, when compared to a pure hydrogen aircraft, given its fuel flexibility.
   - Aircraft ferry range operations (delivery or travel to maintenance centers) is facilitated since the aircraft may be refueled at practically all airports on the globe.
   - Aircraft second or third operating life in developing countries, where the Hydrogen infrastructure may take much longer to be implemented, is enabled.
4) Potential aircraft safety increase
   - Capability of using a traditional fuel (Jet Fuel or SAF) during critical conditions, such as Go-around, rain & hail, take-off and approach and landing, may decrease operational risks, especially at the early adoption phase.
   - Redundant fuel sources and storage increases safety. It may allow for a single tank architecture for either SAF/Jet Fuel or hydrogen, or other fuel system architecture simplifications.

### Example Non-Limiting Detailed Description of a Dual Fuel Aircraft

The following discussion provides background context on how an aircraft can operate using dual fuels (e.g., cryogenic and non-cryogenic fuels). A schematic layout of an example embodiment aircraft is shown in Figure 1, and Figure 1a shows an example aircraft including cryogenic and non-cryogenic fuel tanks. Main components are listed from 1 to 8. A core engine (2), comprising a compressor, combustion chamber and a turbine (mechanically coupled to the compressor), is defined as the engine core. The engine core (2) provides torque to drive the propulsor (3), which provides propulsive thrust to the aircraft (Figure 1a). A variety of core engine arrangements may be considered, including two or more shaft architectures, often found in gas turbine engines. In some embodiments, the referred propulsor (3) may be a Propeller (ducted or unducted, single plane or multi-planes, co-rotating or contrarotating) or a Fan. Thus, in one embodiment, the engine core (2) and propulsor (3) may together comprise a turboprop (see Figure 1A). There may be plural turboprops on the same aircraft, each of which have dual (or more) fuel engine cores. In one embodiment or operating mode, one turboprop on the aircraft could consume cryogenic fuel while another turboprop on the aircraft could consume non-cryogenic fuel, or in another embodiment or operating mode both turboprops could consume cryogenic fuel, or in another embodiment or operating mode both turboprops could consume non-cryogenic fuel.

In one embodiment, the core engine (2) is modified or specifically designed to be able to operate with non-cryogenic fuels such as Jet A, Jet A-1, Jet B, SAF, etc. and cryogenic fuels in gaseous or liquid forms (e.g., hydrogen or methane). The consumption of each fuel type may be concurrent or independent, depending on the mixing fuel strategy of each mission.

Here, we use the term "non-cryogenic fuel" to refer to a fuel that is naturally in the liquid state when stored at typical aircraft environment temperatures and reasonable pressures (e.g., 1 atmosphere); and we use the term "cryogenic fuel" to refer to a fuel that requires storage at extremely low (cryogenic) temperatures in order to maintain it in a liquid state. Cryogenic temperatures are typically considered to be temperatures below -150 degrees centigrade. Hydrogen is an example of a cryogenic fuel because at ambient sea-level pressures such as 1 atmosphere it becomes a liquid only at cryogenic temperatures such as below - 250 degrees centigrade. Conventional jet fuel (aviation turbine fuel or ATF) is an example of a non-cryogenic fuel because it is a liquid at typical ambient temperatures and pressures an aircraft encounters during fueling, taxiing and operation. See e.g., DEF STAN 91-91 and ASTM specification D1655. Common jet fuel freezes at around -40 to -53 degrees Centigrade depending on type, and has a boiling point that is about 176 degrees Centigrade, It is thus in the liquid state at all typical ambient temperatures a typical commercial jet aircraft encounters.

As Figure 1a shows, the non-cryogenic fuel tanks (1) are installed on the aircraft wings or fuselage, and the cryogenic fuel tanks (4) (storing majorly either gaseous or liquid hydrogen) may be installed on the aircraft fuselage or in other aircraft locations, such as on wing pods (if present) or the like. Typically, one cryogenic fuel tank and one non-cryogenic fuel tank are responsible for (alternately or together) feeding one engine, however aircraft safety assessment considerations may allow tank sharing between engines. The wing non-cryogenic fuel can be used as motive flow (e.g. engine variable inlet guide vanes actuation) and for engine oil cooling, returning to the tank without being used, even when the fuel being consumed is the cryogenic fuel. This minimizes the changes in engine hardware and/or technology to perform the motive and cooling functions, reducing risks and investments needed to develop and certify a cryogenic or dual-fuel aviation engines. Thus, in one embodiment, the fuel controller (2) controls the system so that non-cryogenic fuel continues to be used in a conventional fashion to provide motive flow and/or engine oil cooling of the core engine, while the core engine burns cryogenic fuel to propel the aircraft. This approach in one embodiment allows the non-cryogenic fuel to be held in reserve while continuing to use that non-cryogenic fuel for important long proven secondary uses that do not use up, consume or exhaust the non-cryogenic fuel.

Additionally, the cryogenic fuel lines that feed the engines may be directed through the non-cryogenic fuel tanks in order to keep the non-cryogenic fuel temperature within acceptable flammability limits for its fuel vapors and eliminating or minimizing the need of a tank inertization system, saving aircraft weight and further improving fuel savings and minimizing emissions. Thus, the introduction of cryogenic fuel to the system permits the cryogenic fuel to be used to replace prior non-cryogenic fuel cooling systems that might otherwise be necessary, reducing the costs of safely maintaining non-cryogenic fuel on board the aircraft.

As Figure 1 further shows, in addition to the core engine (2) modifications and the cryogenic fuel tanks (4) installation, new systems are introduced: A gasifier system (5) which is responsible for conditioning the cryogenic fuel to be fed to the core engine combustor (2) (i.e., converting the cryogenic liquid fuel to a gas), and a venting system (6), which is responsible for maintaining the cryogenic fuel tanks' internal pressure within safe limits as the cryogenic fuel boils off due to heat from the airplane environment. See e.g., Winnefeld et al, "Modelling and Designing Cryogenic Hydrogen Tanks for Future Aircraft Applications," Energies 11, 105 (2018) doi:10.3390/en11010105. The venting system (6) for example may be designed to monitor temperature and pressure of the cryogenic fuel tanks and provide controlled venting of those tanks to the atmosphere in order to avoid excessive pressure building up within the tanks as the cryogenic fuel they contain boils off. The cryogenic fuel tanks (1) would typically be designed with sufficient thermal insulation to avoid excessive boil off, and would be recharged with cryogenic fuel at cryogenic temperature each time the aircraft is refueled after landing.

An Aircraft fuel control system (7) is responsible to operate and optimize fuel source mixing strategies at any flight phase, enabling different mixing strategies objectives, as outlined in the provided mission profiles and in the Protection Focus Section below. The aircraft fuel control system (7) is also responsible to set the fuel source mixing strategy in exceptional conditions, like aircraft or engine component failures (in-flight or to allow dispatch with failed components), adverse weather conditions (e.g., rain and hail), etc.; or in conditions demanded by the engine (e.g., In-flight starting, in sub-idle conditions, when detecting operability issues, etc.). The fuel mixing strategy may involve both engines consuming the same fuel or even a first engine consuming the non-cryogenic fuel and a second engine consuming the cryogenic fuel. An engine control system (8) is responsible for implementing the aircraft fuel control system-defined fuel mixing strategy in the most suitable manner in terms of engine steady state and transient performance and operability characteristics, as well as accommodating failures. Some functions of the Aircraft Fuel Control System may be embedded in the Engine Control System if bringing benefits in terms of robustness, safety or cost.

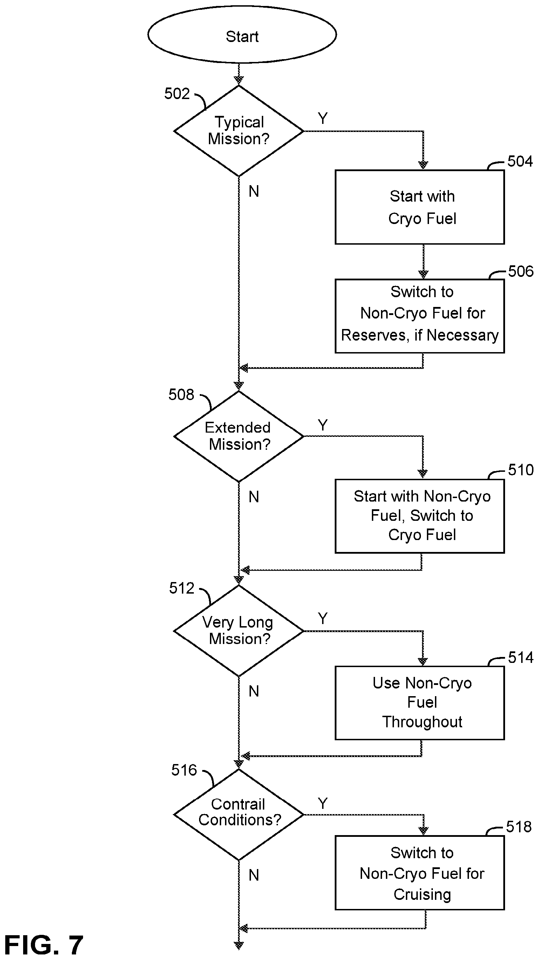

Each of these control systems (7), (8) may be implemented by a combination of hardware and software, for example one or more controllers or systems on chips (SOCs) connected to data buses and executing software instructions shown in Figure 7 that are stored in non-transitory memory such as programmable semiconductor FLASH memory. The control system (7) produces output signals that enables the control system to control valves to selectively open and close, thereby selectively routing cryogenic fuel or standard non-cryogenic fuel to the dual or multi fuel engine(s). In one embodiment, a fuel mixing apparatus may be employed to mix the standard non-cryogenic fuel and the cryogenic fuel (in desired, controllable mixing ratios) such that the dual fuel engine (3) may burn a mixture of standard non-cryogenic fuel and cryogenic fuel.

Example Aircraft Operating Modes For Different Phases of Aircraft Flight: Cryogenic fuel, non-cryogenic fuel or both cryogenic and non-cryogenic fuel

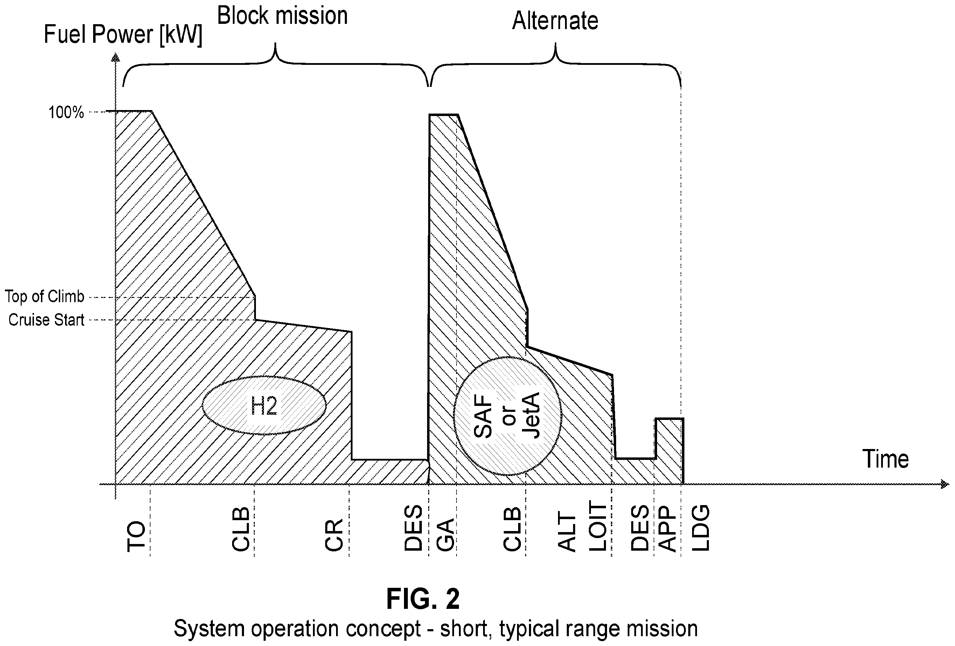

The proposed environmentally friendly aircraft architecture allows a more fuel efficient aircraft, provides fuel flexibility for the aircraft operator, allowing it to use a fuel(s) that has/have lower environmental impact, letting the operator adopt an environmentally friendly aircraft before the cryogenic refueling infrastructure is fully available at its route network. It also allows the operator to choose between Jet Fuel, SAF or hydrogen based on mission requirements (range, payload), airport fuel availability and fuel costs. Among the possible fuel usage and/or mixing possibilities, a few are briefly discussed below:
Typical range mission (Figure 2): Regional aircraft have much shorter typical operating ranges than their design missions (e.g. Turboprops typical missions 200 - 300 nmi, Jets 400 - 600 nmi, while their design maximum ranges are from 2 to 5 times these distances). The typical missions cover around 80% of the complete operating network. Therefore, a possible mixing strategy for the typical mission is presented in Figure 2 which starts with cryogenic fuel and later switches to non-cryogenic fuel if necessary. This strategy maximizes CO2 reduction. In that instance, Go-around is performed with Jet Fuel/SAF which is otherwise kept in reserve and not burned unless necessary (see Figure 7 blocks 502, 504, 506):
Take-off and initial climb: hydrogen
Climb: hydrogen
Cruise: hydrogen
Approach and Landing: hydrogen
Reserves: SAF/Jet Fuel

Additionally to the representation of Figure 2, other mixing strategies may be considered in order to encompass missions where other factors play a role (wind, traffic, weather, etc.), leading to a higher or lower block fuel than originally planned. This may involve, but is not limited to: carrying extra hydrogen (for either the main mission or to be used during Go-around), momentarily using Jet Fuel/SAF during flight (to account for unexpected consumption, to operate under rain or hail, etc.), shifting to Jet Fuel/SAF at final descent to perform the Go-around with Jet Fuel/SAF if needed. In-flight fuel shifting may be performed one engine at a time to increase the system overall reliability. Therefore, the aircraft fuel system control is capable of switching fuels for each engine individually during the flight. The mixing strategy for conditions like these may depend on specific design features of the dual fuel engines that will be installed on the environmentally friendly aircraft. In one example embodiment shown, TO, CLB, CR, DE, APP and LDG phases of "normal" or expected flight are executed using cryogenic fuel, and additional, extra or in some cases unexpected flight phases such as additional CLB, GA, ALT, LOIT, additional DES flight phases are performed using non-cryogenic fuel, where these phases of flight are defined as follows:

| | |
|---|---|
| TO | Takeoff |
| CLB | Climb |
| CR | Cruise |
| DES | Descent |
| GA | Go Around |
| ALT | Alternate Route |
| LOIT | Loiter |
| APP | Approach |
| LDG | Landing or Landing Roll |

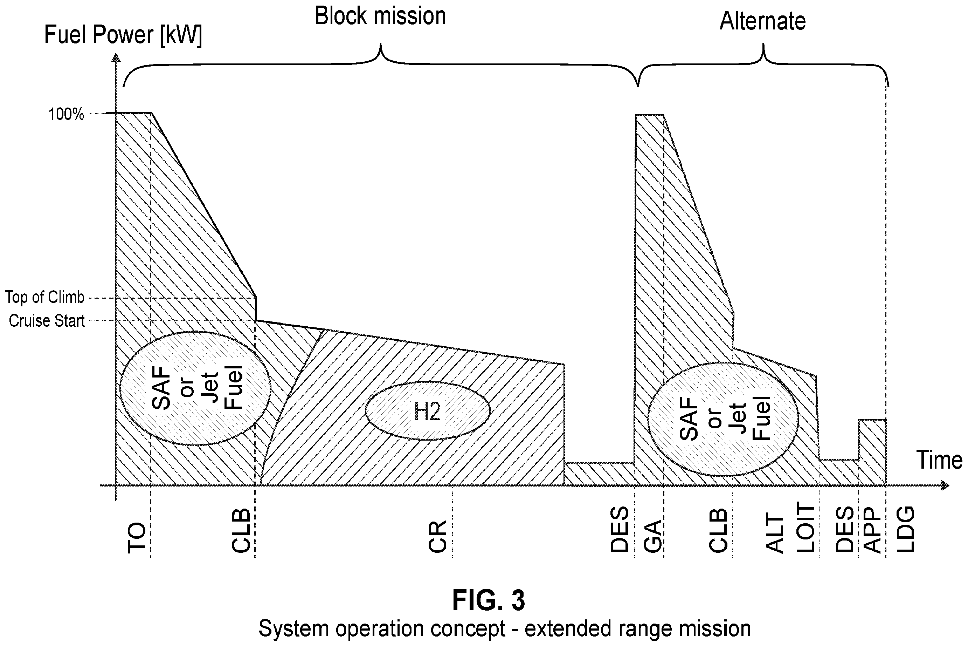

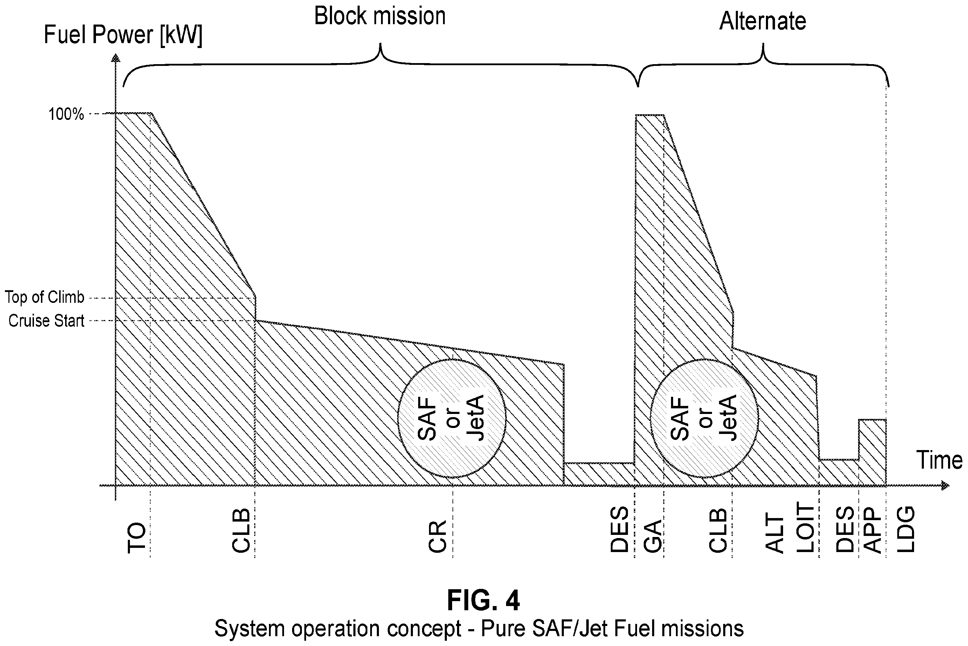

Extended range mission (Figure 3): Around 20% of regional aircraft operations involve mission ranges above the typical sectors. Although a smaller percentage of the missions, these missions are important to enable a profitable operating network, since these smaller aircraft may connect airports of greater distances with smaller demands. For these longer-range missions, a mixing strategy that uses Jet Fuel/SAF to enable a range extension may be employed. In this case, because the non-cryogenic fuel heating value is lower than that of hydrogen, it is more efficient from the aircraft weight standpoint to use the non-cryogenic fuel in the beginning of the mission, reducing the aircraft weight faster in the beginning of the flight, leaving the consumption of the hydrogen closer to the destination. See Figure 7, blocks 508, 510:
Take-off and initial climb: SAF or Jet Fuel
Climb: SAF or Jet Fuel
Cruise: hydrogen + SAF/Jet Fuel for range extension
Approach and Landing: SAF/Jet Fuel
Reserves: SAF/Jet Fuel
Pure SAF / Jet Fuel missions (Figure 4): If the aircraft needs to perform its maximum range missions at low payloads (for example, moving to a maintenance location - ferry range with zero payload), or if it is operating in an airport which does not have hydrogen available, it may utilize the full capabilities of its SAF/Jet Fuel tanks and operate with its hydrogen tanks at minimum level or empty (see Figure 7, blocks 512, 514). For delivery purposes, this mission profile can also be used, or the cryogenic fuel tanks can be filled with hydrogen as reserve fuel, even if hydrogen is not available along the delivery route, since hydrogen is not expected to be needed during the delivery flight. This strategy reduces the aircraft weight (given the higher heating value of hydrogen), decreasing emissions.

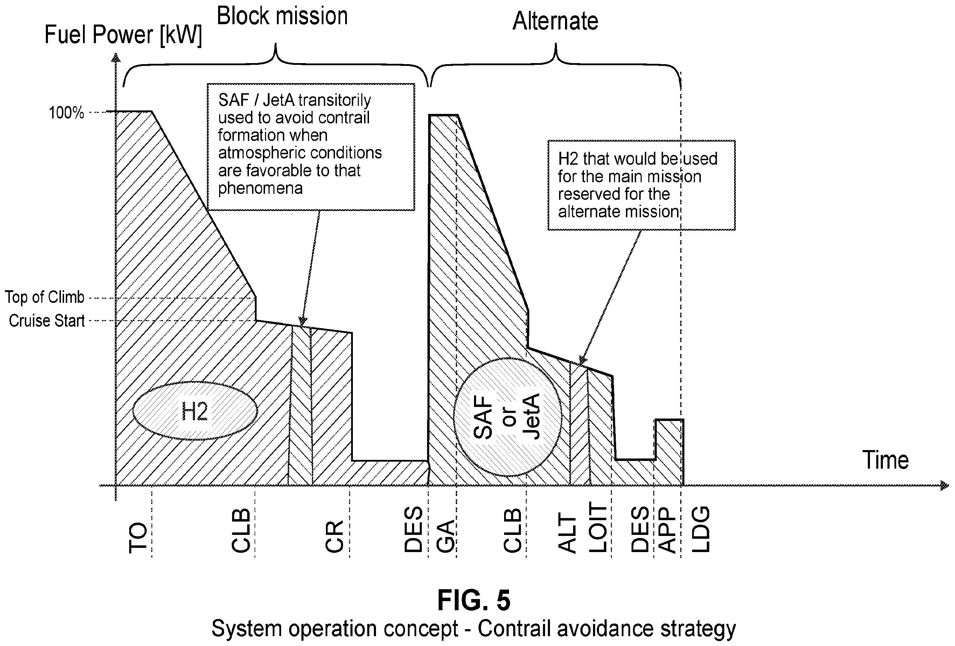

Contrails avoidance strategy (Figure 5): at specific atmospheric conditions (temperature, humidity), contrails may be formed from the exhaust plumes of gas turbines. Hydrogen combustion produces higher amounts of water vapor than Jet Fuel or SAF, which can mean leaving larger and more visible contrails. The dual fuel strategy can be useful if the aircraft encounters the referred atmospheric conditions during its main mission phase, since the Jet Fuel/SAF originally provisioned for the range extension or the alternate mission can be transitorily used to minimize contrails (Figure 7, blocks 516, 518) while the aircraft tries to change to a different flight altitude where the contrails-favorable conditions are not present. An example of such utilization is provided in Figure 5.

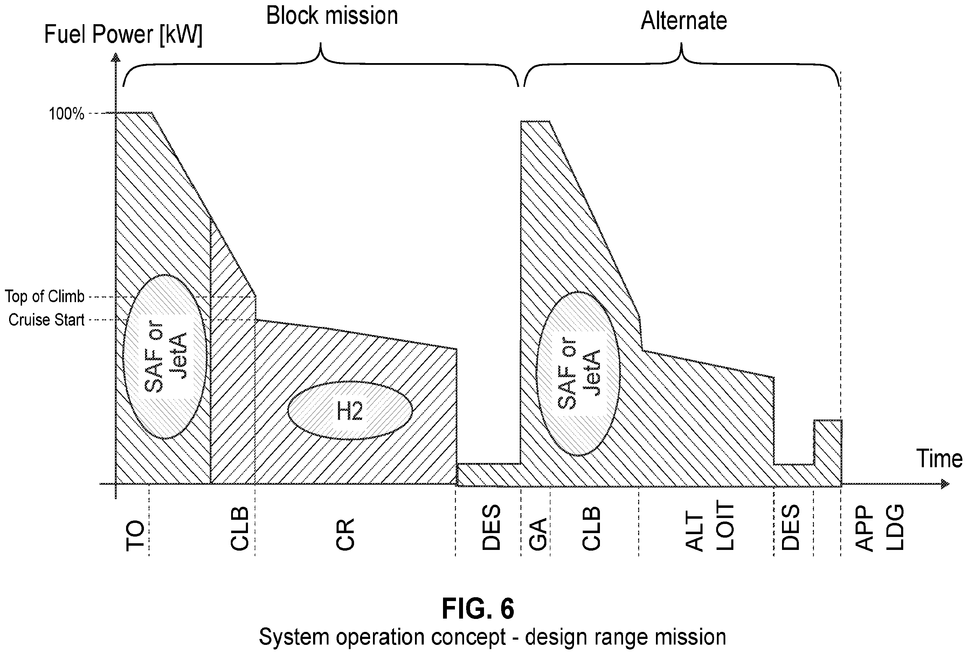

Figure 6 shows an example system operation concept based on a design range mission used to size the non-cryogenic fuel tanks maximum volumetric capacity. Specifically, Figure 6 shows how an initial phase of flight (Takeoff or TO) can use non-cryogenic (e.g., SAF or JetA) fuel, the aircraft switches over to cryogenic fuel during the climb and cruise phases, the approach and landing phases use SAF/Jet fuel, and reserves are SAF/Jet fuel:
Take-off and initial climb: SAF or Jet Fuel
Climb: Transition from SAF/Jet Fuel to hydrogen
Cruise: hydrogen
Approach and Landing: SAF/Jet Fuel
Reserves: SAF/Jet Fuel

### Example Design Process To Obtain An Aircraft With "Right Sized" Fuel Tanks

To enable the flight operations described above, it is important in example embodiments to "right size" the cryogenic and non-cryogenic fuel tanks. Such right sizing ensures the aircraft can carry sufficient quantities of each type to enable desired flight operations, without incurring excess weight penalties such as by having an oversized cryogenic tank(s). The volumetric capacities of cryogenic and non-cryogenic tanks respectively of the aircraft can thus be designed to support desired operating modes that enable maximum use of "green" liquid hydrogen fuel while ensuring fuel reserves including sufficient quantities of non-cryogenic fuel(s).

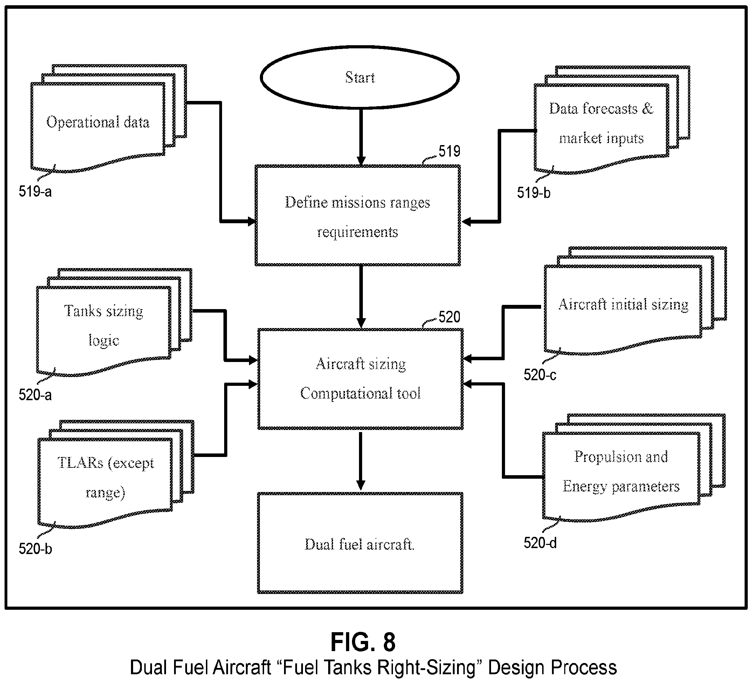

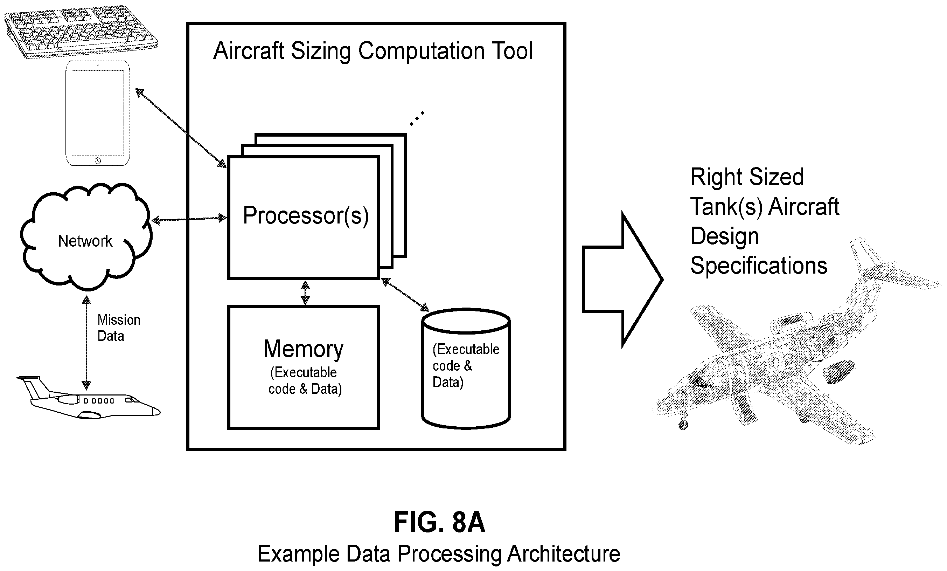

Figure 8 provides an overview of an example "fuel tanks right-sizing" design process, that results in a dual fuel aircraft that by using the cryogenic fuel can reduce carbon emissions in the vast majority of missions (mission ranges up to and equal to the typical mission), while still offering longer range capabilities by using a mixture of non-cryogenic and cryogenic fuels, and also operational flexibility by using the non-cryogenic fuel alone.

The example process shown in Figure 8 in one embodiment is performed at least in part by the example data processing architecture shown in Figure 8A, which includes at least one computer processor connected to a non-transitory memory (e.g., random access memory, disk storage memory, etc.) storing instructions that, when executed by the at least one processor, control the at least one processor to perform the operations shown. The at least one processor may be connected to user interface devices such as displays and input devices, and may also be coupled via a network to various other computing devices including for example mission monitoring equipment on board various aircraft (and/or a database containing data previously harvested from aircraft). The at least one processor produces Right Sized Tank(s) Aircraft Design Specifications that are then used to manufacture and build one or more aircraft.

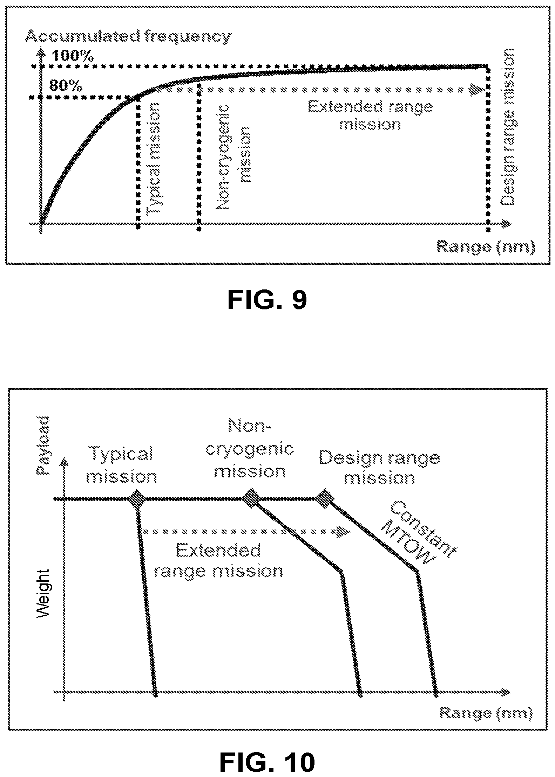

The first step (block 519) is to define range requirements for the typical mission, non-cryogenic fuel mission and design range mission. This is performed through a collection of aircraft operational data (block 519-a), data forecasts and market inputs (block 519-b). Sources for these datasets may include data mining of current aircraft operators' networks, interviews and advisory boards with potential aircraft customers, network simulation software, and/or Artificial Intelligence-powered network predictors. The missions are defined as per below, and Figure 9 and Figure 10 provide further graphical insight.

In particular, Figure 9 shows example mission ranges accumulated frequency across a number of aircraft missions, where the y axis indicates accumulated frequency of occurrence across many missions and the x axis refers to range (distance) in nautical miles ("nm"). Note that the collected data will vary based on size/type of aircraft and usage of the aircraft (e.g., regional flights, long distance flights with cargo, narrow body, wide body, or business aircraft, etc.)

Figure 10 shows a payload range diagram with associated missions, plotting payload weight versus mission range for a typical mission, a non-cryogenic mission, and a design range mission. In such analysis:
"Typical mission" is the mission range that covers around 80% of all forecasted operations (in terms of accumulated range frequency). Other accumulated frequency percentages from 50% to 90% may be chosen as the typical mission definition. The aircraft Take-Off Weight (TOW) is below the aircraft Maximum Take-Off Weight (MTOW) when the typical mission is performed. In non-limiting examples, the typical mission for a turboprop powered regional aircraft may be between 200 and 300 nautical miles, while for jet powered regional aircraft may be between 400 and 600 nautical miles.
"Pure non-cryogenic mission" (or "non-cryogenic mission" shown in Figure 10) is the mission range that the aircraft can perform with the cryogenic tanks at their minimum level.
"Extended range missions" in Figure 10 are all missions ranges comprised between the typical mission and the design range mission.
"Design range mission" of Figure 10 is the mission range that covers 100% of all forecasted operations and represents the maximum range of the aircraft at its maximum payload. This mission is denominated as "design mission" since it determines the aircraft MTOW. In non-limiting examples, the design range mission for a turboprop powered regional aircraft may be between 500 and 1,000 nautical miles, while for jet powered regional aircraft it may be between 1,500 and 3,000 nautical miles.

Referring again to Figure 8, the second step (block 520) is to feed e.g., three datasets into a computational tool that will perform the aircraft sizing, i.e., define its required wing area, engine thrust levels, design weights and overall performance:
Tanks sizing logic (block 520-a): The tanks sizing logic, as previously described, is to size the cryogenic fuel tank (or tanks) to provide enough energy only for the typical mission range, and size the non-cryogenic fuel tank (or tanks) to provide enough energy for the regulatory (i.e., regulation-mandated, see e.g., 14 CFR § 91.151) reserves and for the design range mission. The non-cryogenic fuel tank (or tanks) may be oversized (when compared to the design range requirement) to provide operators the flexibility to trade payload and range, as usually done in regular JetA-powered aircraft. This does not bring any impact in terms of design weights since the trade is performed at constant MTOW, requiring only the volume availability inside the aircraft wings (in other words, there is already necessary space within the wings of most aircraft to accommodate additional non-cryogenic fuel storage).

Top-Level Aircraft Requirements (TLARs) (block 520-b): Set of requirements (excluding range requirements which were already defined in block 519) that, together with range requirements, will define aircraft wing area and engines thrust levels. Examples: field performance (take-off and landing), climb performance, cruise performance.

Aircraft initial sizing (block 520-c): Initial geometric, wing area, and engine thrust level definitions. Used as a starting point for the sizing process and to estimate the initial aircraft empty weight and aerodynamic performance (drag polars, high-lift devices coefficients, etc.).

Propulsion and energy parameters (block 520-d): Encompasses characteristics of the dual fuel powerplant, such as weight, overall dimensions, available thrust (or power) and fuel flow at different flight conditions and for the different fuels (cryogenic and non-cryogenic), and parameters of the fuel systems, such as cryogenic tanks gravimetric index (defined by the ratio between the cryogenic fuel mass and the sum of the tank structure and the cryogenic fuel mass), possible form factors (geometric shapes, diameter to length ratio), among others.

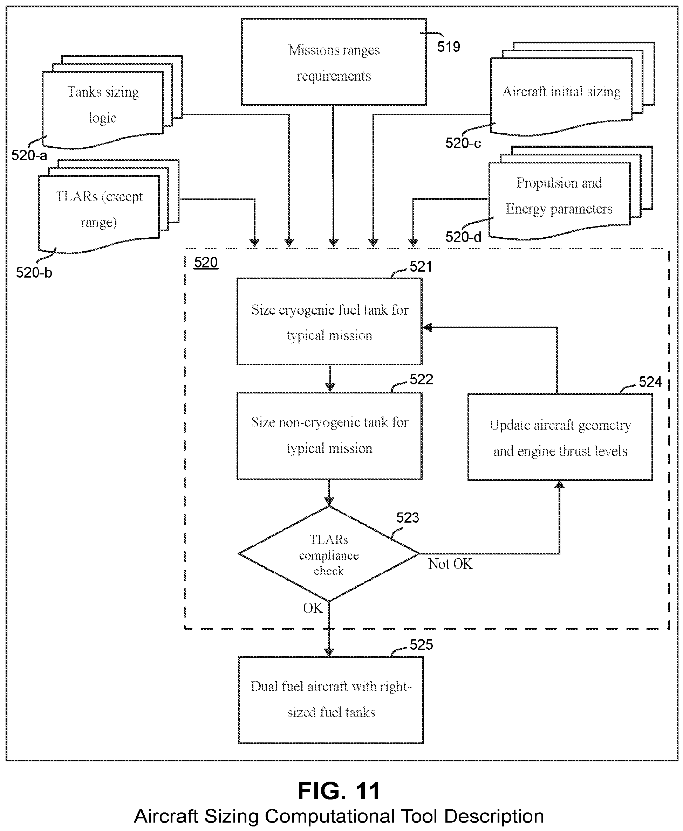

After all inputs are made available, the aircraft sizing computational tool operated by the at least one processor described above and shown in Figure 8A will perform the iterative calculations such as presented in Figure 11:
(Block 521) Size the cryogenic fuel tank (or tanks) in order to provide enough energy only for the prescribed typical mission, allocating its mass, volume and other applicable characteristics into the aircraft overall computations.
(Block 522) Size the non-cryogenic fuel tank (or tanks) to provide enough energy for the regulatory reserves and for the design range mission, already taking into consideration the available energy of the cryogenic fuel tank (or tanks) and added weight and drag of the mass and volume allocations for the cryogenic fuel tank (or tanks).
(Block 523) Check if prescribed TLARs are met by the obtained aircraft geometry and engine thrust levels; if they are not, change the aircraft geometry or engine thrust levels and return to step (1).
(Block 525) If TLARs are met by the obtained aircraft geometry and engine thrust levels, the dual fuel aircraft design with right-sized fuel tanks is completed.

The process outlined above can be integrated into a Multi-Disciplinary Optimization environment so that trade-offs between specific design variables, such as wing area and engine thrust levels, can be performed. See for example Joaquim R. R. A. Martins et al, 'Multidisciplinary Design Optimization: A Survey of Architectures," American Institute of Aeronautics and Astronautics, Inc., Volume 51, Number 9 (September 2013), doi.org/10.2514/1.J051895.

The resulting fuel tank volumetric values are used in a manufacturing process to manufacture right sized fuel tanks such as integral (tanks work as a load-carrying element of the aircraft structure) or non-integral (tanks do not carry loads from the aircraft structure, being "stand-alone") type tanks that are then installed in or integrated into a particular aircraft. Information concerning installation of fuel tanks into aircraft may be found for example in US 20110272526 A1, incorporated by reference. For example, the cryogenic fuel tanks may be installed in the main fuselage, and the conventional jet fuel tanks may be in the wings. The conventional wing based jet fuel tanks may for example comprise leak-tight chambers within the structures of the wings themselves. Weight and other ratios of the aircraft may be adjusted based on the amount of fuel the wing tanks will hold in a right sized fuel tank design. Similarly, the amount of space within the main fuselage for cryogenic fuel tanks may be defined and the tanks themselves manufactured and installed or integrated based on the analysis as described herein.

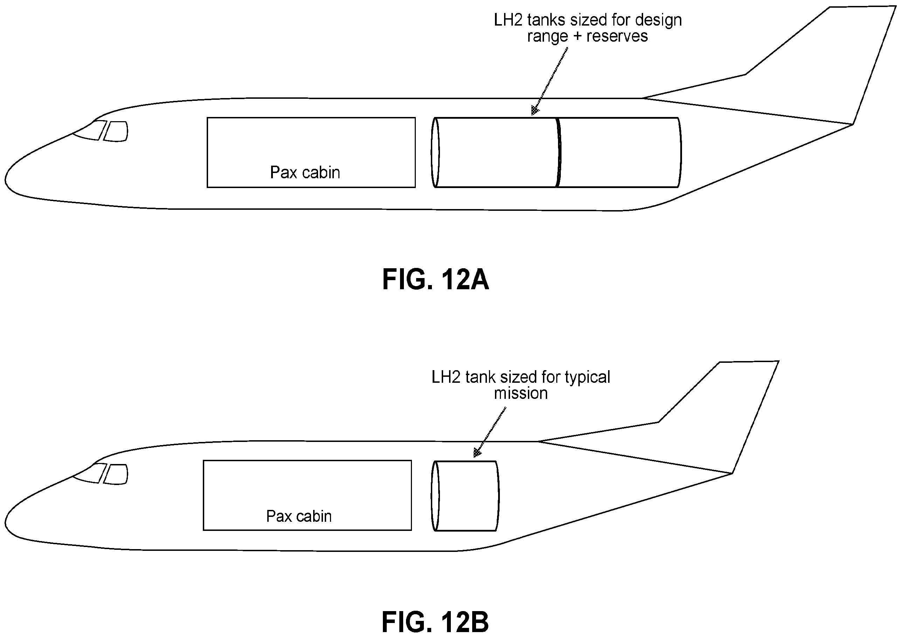

An example resulting aircraft with right sized fuel tanks is shown in Figures 12A, 12B. The Figure 12A diagram shows example liquid hydrogen tanks sized for design range and reserves. The Figure 12B diagram shows an example liquid hydrogen tank sized for a typical mission. The aircraft in Figure 12A can be designed to have a shorter fuselage and the same pax cabin size as the Figure 12B aircraft. In example embodiments, cryogenic fuel tanks will be cylindrical or spherical (in this case because they hold the same volume with less external area, compared to a rectangular or cubic tank). Therefore they receive less heat from the environment (or lose less "cold" to it) and keep their cryogenic temperatures longer.

All patents and publications cited above are incorporated herein by reference.

While the invention has been described in connection with what is presently considered to be the most practical and preferred embodiment, it is to be understood that the invention is not to be limited to the disclosed embodiment, but on the contrary, is intended to cover various modifications and equivalent arrangements included within the spirit and scope of the appended claims.

## Claims

1. A process for designing an aircraft comprising:
obtaining operational data defining missions ranges requirements;
operating at least one processor providing an automated aircraft sizing computational tool based on the defined missions ranges requirements, tanks sizing logic, Top-Level Aircraft Requirements, and aircraft geometry and engine thrust levels, to iteratively develop at least cryogenic fuel tank size for a particular aircraft; and
configuring a cryogenic fuel tank based on the developed at least cryogenic fuel tank size for a particular aircraft.

2. The process of claim 1 wherein operating further comprises developing the at least cryogenic fuel tank size based on propulsion and energy parameters.

3. The process of claim 1 or 2 wherein operating further comprises developing the at least cryogenic fuel tank size based on an aircraft requirements compliance check, and performing an iteration with updated geometry and engine thrust levels if the compliance check fails.

4. The process of one of the preceding claims wherein the operating develops sizes for both a cryogenic fuel tank and a non-cryogenic fuel tank.

5. The process of one of the preceding claims wherein the operating produces the at least cryogenic fuel tank size for a typical mission.

6. The process of one of the preceding claims wherein the operating produces a non-cryogenic fuel tank size to provide energy for the regulatory fuel reserves and for a design range mission.

7. The process of one of the preceding claims further including manufacturing and installing in or integrating into an aircraft, a cryogenic fuel tank based on the developed at least cryogenic fuel tank size for a particular aircraft.

8. An aircraft having a right sized cryogenic fuel tank, produced based on a process comprising:
obtaining operational data defining missions ranges requirements;
operating at least one processor providing an automated aircraft sizing computational tool based on the defined missions ranges requirements, tank sizing logic, Top-Level Aircraft Requirements, and aircraft geometry and engine thrust levels, to iteratively develop at least cryogenic fuel tank size for a particular aircraft; and
configuring a cryogenic fuel tank based on the developed at least cryogenic fuel tank size for a particular aircraft.

9. The aircraft of claim 8 wherein operating further comprises developing the at least cryogenic fuel tank size based on propulsion and energy parameters.

10. The aircraft of claim 8 or 9 wherein operating further comprises developing the at least cryogenic fuel tank size based on an aircraft requirements compliance check, and performing an iteration with updated geometry and engine thrust levels if the compliance check fails.

11. The aircraft of one of claims 8 to 10 wherein the operating develops sizes for both a cryogenic fuel tank and a non-cryogenic fuel tank.

12. The aircraft of one of claims 8 to 11 wherein the operating produces the at least cryogenic fuel tank size for a typical mission.

13. The aircraft of one of claims 8 to 12 wherein the operating produces a non-cryogenic fuel tank size to provide energy for the regulatory fuel reserves and for a design range mission.

14. The aircraft of one of claims 8 to 13 further including manufacturing and installing in or integrating into an aircraft, a cryogenic fuel tank based on the developed at least cryogenic fuel tank size for a particular aircraft.

15. An aircraft design system comprising:
at least one processor, and
a non-transitory memory connected to the processor,
the memory storing instructions that when executed by the at least one processor, control the at least one processor to perform the method of one of claims 1 to 7..
